(19) Europäisches Patentamt / European Patent Office / Office européen des brevets

(11) **EP 3 407 055 A1**

(12) **DEMANDE DE BREVET EUROPEEN**

(43) Date de publication:
**28.11.2018 Bulletin 2018/48**

(51) Int Cl.:
**G01N 21/95** (2006.01)  **G01N 21/64** (2006.01)
**H01L 21/66** (2006.01)  **H02S 50/00** (2014.01)

(21) Numéro de dépôt: **18172737.1**

(22) Date de dépôt: **16.05.2018**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **22.05.2017 FR 1754523**

(71) Demandeurs:
• **Centre National de la Recherche Scientifique**
  **75016 Paris (FR)**
• **Institut Photovoltaïque d'Ile de France - IPVF**
  **92160 Antony (FR)**
• **Ecole Polytechnique**
  **91120 Palaiseau (FR)**
• **Total Marketing Services**
  **92800 Puteaux (FR)**
• **Electricité de France**
  **75008 Paris (FR)**

(72) Inventeurs:
• **EL-HAJJE, Gilbert**
  **78110 LE VESINET (FR)**
• **ORY, Daniel**
  **92260 Fontenay aux Roses (FR)**
• **LOMBEZ, Laurent**
  **92000 NANTERRE (FR)**
• **GUILLEMOLES, Jean-François**
  **Meguro-ku, Tokyo 153-8904 (JP)**

(74) Mandataire: **Priori, Enrico**
**Marks & Clerk France**
**Immeuble "Visium"**
**22, avenue Aristide Briand**
**94117 Arcueil Cedex (FR)**

(54) **SPECTROSCOPIE QUANTITATIVE DE DENSITE DE DEFAUTS ELECTRONIQUES DANS UN PHOTORECEPTEUR EN COUCHES MINCES, NOTAMMENT DANS UNE CELLULE SOLAIRE**

(57) L'invention propose une caractérisation de couche mince réalisée dans un matériau semiconducteur à propriétés photovoltaïques, comportant:
- éclairer (S1) le matériau de la couche mince pendant au moins une impulsion lumineuse, avec une lumière comprenant au moins une longueur d'onde inférieure à une longueur d'onde du gap du matériau,
- mesurer (S2), après cette impulsion lumineuse, une luminescence issue du matériau, décroissante en fonction du temps, et
- estimer (S3), en fonction de la mesure de luminescence précitée, une densité de défauts ($\Psi_D$) dans le matériau de la couche mince.

FIG. 12

EP 3 407 055 A1

**Description**

La présente invention concerne la caractérisation de photorécepteurs, notamment de cellules solaires, pour un contrôle de qualité par exemple en fin de procédé de fabrication.

La qualité du transport des porteurs de charges électriques au sein des photorécepteurs à propriétés photovoltaïques, notamment de cellules solaires est un indicateur de performance photovoltaïque. Cet indicateur est caractérisé par la mobilité des porteurs de charge, leur longueur de diffusion et leur temps de vie.

Les cellules solaires en couches minces, notamment à base de matériaux chalcogénures, ne sont pas idéales en termes de qualité de transport de charges. Ceci est principalement dû à l'existence d'une densité non négligeable de défauts au sein du matériau photovoltaïque. Ces défauts physico-chimiques se comportent comme des pièges électroniques limitant la quantité de courant qui peut être extraite des cellules solaires en perturbant l'arrangement cristallin qui forme le matériau photovoltaïque.

Cette densité de défauts contribue donc directement à la dégradation de la mobilité des porteurs de charges, leur longueur de diffusion, ainsi que leur temps de vie. En fonction de leur nature physico-chimique, ces pièges électroniques possèdent des niveaux énergétiques différents au sein du matériau photovoltaïque. Par conséquent, d'un niveau énergétique à un autre, ces pièges agissent différemment sur le transport des porteurs de charge, et ont donc des effets respectifs différents sur la performance photovoltaïque globale. Il convient ainsi d'accéder quantitativement à la distribution énergétique de ces défauts.

De nos jours, les technologies dites « CIGS » (chalcogénures quaternaires de type I-III-VI$_2$ à base de cuivre, indium-gallium et sélénium-soufre) et « CdTe » (tellurure de cadmium) représentent la part principale de la fabrication des cellules solaires en couches minces, dites de « deuxième génération ». Dans le but d'augmenter leurs rendements, il est recherché une minimisation, voire l'élimination de leur densité de pièges électroniques.

Des techniques de caractérisations optoélectroniques des cellules solaires ont alors été proposées. Elles visent à caractériser ces défauts en déterminant leur nature, leur densité et leur localisation spatiale et énergétique au niveau de l'empilement de couches minces.

A titre d'exemple, on peut citer la technique dite « DLTS ». Il s'agit d'une technique de caractérisation reposant sur des mesures capacitives ou « technique DLTS » (pour « Deep Level Transient Spectroscopy », ou encore C(V,T,f)) permettant de mesurer la densité de défauts au sein du photorécepteur, en tant que semiconducteur. Ces techniques consistent en une application simultanée d'une tension négative continue ainsi qu'une tension négative pulsée aux bornes de la cellule solaire. Une fois la tension pulsée appliquée, un déclin temporel de la capacitance du semiconducteur est obtenu. Ensuite la capacitance est mesurée pour deux instants différents du déclin et la différence entre les deux valeurs obtenues est calculée. Ces opérations sont répétées tout en variant la température du semiconducteur. Finalement, le profil de la différence temporelle des capacitances est établi en fonction de la température. De ce profil, la concentration relative des défauts et leurs énergies d'activation sont calculées.

Pour appliquer cette technique de caractérisation, la liste d'équipements suivante est nécessaire :

- un générateur de tension continue,

- un générateur de tension pulsée,

- un cryostat,

- un mélangeur de fréquence,

- un générateur de phase,

- un capacimètre,

- un circuit de refroidissement,

- un système de pompes permettant de préserver la cellule solaire sous vide, et

- un amplificateur de fréquences.

Outre la quantité de matériels nécessaires, la technique DLTS présente d'autres inconvénients.

Elle nécessite des conditions couteuses de mesures à de très basses températures, de l'ordre de 50K (-223°C) et nécessite de longs temps de mesure. Elle est difficilement maitrisable.

En outre, elle nécessite un contact électrique direct des cellules solaires. Ces dernières doivent alors être finies, et comporter l'empilement complet de couches minces. Dans ce cas, la caractérisation d'une couche individuelle de l'empilement et en particulier de l'absorbeur photovoltaïque est impossible. Ces aspects éliminent donc la possibilité d'une utilisation industrielle de cette technique, pour une caractérisation pas à pas des couches déposées. La technique DLTS ne permet pas alors de mesurer la variation de densité de défauts en fonction des différentes étapes du processus de fabrication industrielle.

En outre, cette technique impose une condition exigeante de stabilité mécanique car la cellule solaire en contactée en permanence et toute source de vibration peut induire un faux contact et une erreur de mesure. Souvent, les vibrations mécaniques sont produites principalement par le circuit de refroidissement associé au cryostat et les pompes.

La technique DLTS nécessite que la cellule solaire se trouve sous un niveau de vide tel que la pression ambiante est de l'ordre de 10$^{-5}$ millibars. Bien évidemment, une telle condition nécessite un système de pompage continu et par conséquent des vibrations et coûts d'opération plus substantiels encore.

Finalement, la chambre dans laquelle est placée la cellule solaire possède de petites géométries carrées avec des surfaces de l'ordre de quelques centimètres carrés. Seuls les échantillons de cellules solaires de petites surfaces peuvent alors être caractérisés.

Il est connu de l'art antérieur d'illuminer des couches minces de matériaux PV semi-conducteurs afin d'induire une luminescence et d'analyser l'image de cette luminescence pour visualiser les défauts ou dislocations de ces couches minces (voir brevets US 2015/323457 A et 2012/012756 A1). Cependant, ces deux techniques ne sont pas résolues en temps ce qui donne une estimation peu précise de la densité de défaut du matériau.

Il est aussi connu d'estimer la densité de défaut de couches minces de matériaux PV semi-conducteurs à partir de la décroissance de l'intensité du signal de luminescence au cours du temps (voir US 2013/122612 A1, US 2013/140431 A1). Cependant, ces techniques ne permettent pas de sonder les densités de défauts à plusieurs interfaces/profondeurs du matériau.

La présente invention vient améliorer cette situation en visant un autre type de caractérisation.

Elle propose à cet effet un procédé de caractérisation d'une couche mince réalisée dans un matériau semi-conducteur à propriétés photovoltaïques, le procédé comportant:

a. éclairer le matériau de la couche mince en utilisant une pluralité d'impulsions lumineuses successives présentant des longueurs d'onde respectives, différentes entre elles, chacune inférieure à une longueur d'onde de gap d'une portion de ladite couche mince ;
b. effectuer des mesures résolues en temps de la décroissance d'une luminescence, décroissante en fonction du temps, issue du matériau après chaque impulsion lumineuse,
c. estimer, en fonction de chaque mesure de luminescence, une densité de défauts ($\Psi_D$) dans une portion respective du matériau de la couche mince

Ainsi, la présente invention propose une caractérisation basée sur une observation simplement optique et ne nécessitant pas les moyens onéreux et instables de l'art antérieur. Par ailleurs, cette observation optique au sens de l'invention permet de caractériser quantitativement des défauts dans la couche mince déposée et optimiser le cas échéant les conditions de dépôt de cette couche mince. De plus, l'utilisation de longueurs d'onde successives différentes permet de recouper et de confirmer, entre les différentes mesures à différentes longueurs d'onde d'excitation, une estimation de la densité de défaut. Elle permet en outre de sonder des niveaux de gap distincts dans le matériau de la couche mince, et notamment par exemple à l'interface de la couche mince d'absorbeur et du substrat sur laquelle elle est déposée. De là, il est possible d'obtenir la densité de défauts notamment en différentes zones de la couche mince et à différentes hauteurs par exemple. Ainsi, utiliser des longueurs d'onde d'excitation distinctes permet de sonder notamment des localisations particulières (notamment en profondeur Z) de la couche, sans nécessairement se limiter à une caractérisation dans le plan (X,Y) de la couche.

Dans un exemple de mise en oeuvre pratique, le procédé comporte :

- élaborer un modèle de ladite décroissance de luminescence au moins en fonction de la densité de défauts ($\Psi_D$) dans le matériau de la couche mince,
- appliquer le modèle pour une pluralité de valeurs de densité de défauts ($\Psi_D$), et identifier une valeur de densité de défauts qui minimise un écart entre le modèle et la mesure de décroissance de luminescence, et
- définir la valeur identifiée comme étant l'estimation de la densité de défauts ($\Psi_D$) dans le matériau de la couche mince.

Une telle réalisation permet de résoudre un système à plusieurs équations différentielles liant la décroissance de luminescence à la densité de défauts, comme présenté dans la description détaillée plus loin. En bref ici, ces équations différentielles tiennent compte du temps de relaxation des porteurs piégés par des défauts avec des énergies dans des niveaux de Fermi intermédiaires entre la bande de conduction et la bande de valence du matériau. La décroissance dans le temps de la luminescence qui est mesurée est expliquée par ce temps de relaxation (et est d'autant plus lente que ce temps de relaxation est long et que la densité des défauts dans le matériau est élevée).

Dans une réalisation, le procédé comporte en outre :

- estimer, en fonction de la densité de défauts ($\Psi_D$), une tension de circuit ouvert maximale ($\Delta\mu$) du matériau de la couche mince.

Ce paramètre de tension de circuit ouvert maximale (notée $\Delta\mu$ ci-après et dans les dessins annexés) caractérise quantitativement la qualité photovoltaïque du matériau déposé en couche mince. Il s'agit alors d'un paramètre important pour l'appréciation d'un produit photorécepteur, tel qu'une cellule solaire par exemple, comportant ce matériau en couche mince. Il convient de noter que ce paramètre peut être mesuré sur des spectres de photoluminescence classiques (donné par la pente du front montant pour des longueurs d'onde croissantes). Néanmoins, dans l'approche présentée ici, l'estimation de ce paramètre $\Delta\mu$ est basée plus rigoureusement sur la densité de défauts issue des mesures dans le matériau, ce qui correspond physiquement à une détermination plus exacte du paramètre $\Delta\mu$.

Plus particulièrement, il a été observé une relation linéaire en moyenne entre ce paramètre $\Delta\mu$ et la densité de défauts $\Psi_D$, de telle sorte que le paramètre $\Delta\mu$ peut être estimé comme suit, dans un exemple de réalisation :

- à partir d'une pluralité de mesures et d'estimations de la densité de défauts ($\Psi_D$) dans le matériau de la couche mince, on détermine une variation linéaire de la tension de circuit ouvert maximale ($\Delta\mu$) en fonction de la densité de défauts ($\Psi_D$) dans le matériau de la couche mince, et
- à partir de la variation linéaire, on détermine la tension de circuit ouvert maximale ($\Delta\mu$) du matériau de la couche mince.

Cette pluralité de mesures et d'estimations de la densité de défauts ($\Psi_D$) peut être obtenue à différentes longueurs d'onde d'éclairement du matériau de la couche mince, ou en différents points (spatialement) de la couche mince (par exemple trois points de mesure).

Dans une réalisation, l'estimation de la densité de défauts ($\Psi_D$) peut être répétée pour une pluralité de points de la couche mince, afin de cartographier une répartition spatiale de la densité de défauts ($\Psi_D$) dans la couche mince. Une telle réalisation peut permettre par exemple d'identifier une zone de la couche mince avec une grande densité de défauts, ce qui permet par exemple d'améliorer les conditions de dépôt de cette couche mince (en identifiant par exemple une qualité à améliorer de l'interface avec une couche sous-jacente ou un substrat sous-jacent).

En complément ou en variante, l'estimation de tension de circuit ouvert maximale ($\Delta\mu$) peut aussi être répétée pour une pluralité de points de la couche mince, en vue de cartographier une répartition spatiale de la tension de circuit ouvert maximale ($\Delta\mu$) de la couche mince.

Dans une réalisation complémentaire, dans laquelle la couche mince précitée est une première couche mince d'un empilement comportant en outre une deuxième couche déposée sur la première couche, le procédé peut comporter en outre :

- éclairer l'empilement pendant au moins une impulsion lumineuse, avec une lumière incluant au moins une longueur d'onde inférieure à une longueur d'onde d'un gap d'une interface entre les première et deuxième couches,
- mesurer, après ladite impulsion lumineuse, une luminescence issue de ladite interface, décroissante en fonction du temps, et
- estimer, en fonction de ladite mesure de luminescence, une densité de défauts ($\Psi_D$) dans l'interface entre les première et deuxième couches minces.

Une telle réalisation permet alors de caractériser qualitativement et quantitativement, non seulement la couche à propriétés photovoltaïques, mais aussi l'interface avec une couche sur-jacente comme par exemple une couche tampon (classique dans un empilement formant une cellule solaire).

Le procédé peut alors être mis en oeuvre pour un contrôle de qualité de fabrication d'un produit photorécepteur comportant un dépôt dudit matériau en couche mince, le procédé comportant alors dans une telle application :

- comparer la densité de défauts ($\Psi_D$) estimée dans le matériau de la couche mince à une valeur seuil, et

    - en cas de dépassement de la densité de défauts estimée au-delà de la valeur seuil, rejeter le dépôt dudit matériau en couche mince comme non conforme,
    - sinon, poursuivre la fabrication du produit photorécepteur.

En complément ou en variante, le procédé peut comporter :

- comparer, à une valeur seuil, la tension estimée de circuit ouvert maximale du matériau de la couche mince, et

  - si la tension estimée de circuit ouvert maximale est inférieure à la valeur seuil, rejeter le dépôt dudit matériau en couche mince comme non conforme,
  - sinon, poursuivre la fabrication du produit photorécepteur.

En complément ou en variante encore, le procédé peut comporter :

- comparer à une valeur seuil la densité de défauts estimée à l'interface entre les première et deuxième couches précitées, et

  - en cas de dépassement de la densité de défauts estimée au-delà de la valeur seuil, rejeter l'empilement comme non conforme,
  - sinon, poursuivre la fabrication du produit photorécepteur.

Dans une application avantageuse du procédé de l'invention, le produit photorécepteur peut être une cellule solaire comportant un alliage comme matériau semi-conducteur à propriétés photovoltaïques dans la couche mince précitée. Les conditions de dépôts d'un tel alliage nécessitent de bons contrôles notamment :

- de la stoechiométrie d'alliage et
- de la qualité de structure déposée se présentant souvent sous la forme de grains cristallins dans une matrice amorphe.

A titre d'exemple d'une telle structure, on peut citer un matériau de type chalcogénure de stoechiométrie I-III-$VI_2$ (tel que le CIGS comme on le verra plus loin).

La présente invention vise aussi un dispositif de caractérisation d'une couche mince réalisée dans un matériau semi-conducteur à propriétés photovoltaïques, comportant au moins, pour la mise en oeuvre du procédé ci-avant :

- une source d'éclairement comprenant un laser à impulsions, pour éclairer le matériau de la couche mince,
- une unité de comptage de photons pour mesurer la luminescence issue du matériau, et
- une unité de traitement informatique pour estimer la densité de défauts ($\Psi_D$) dans le matériau de la couche mince.

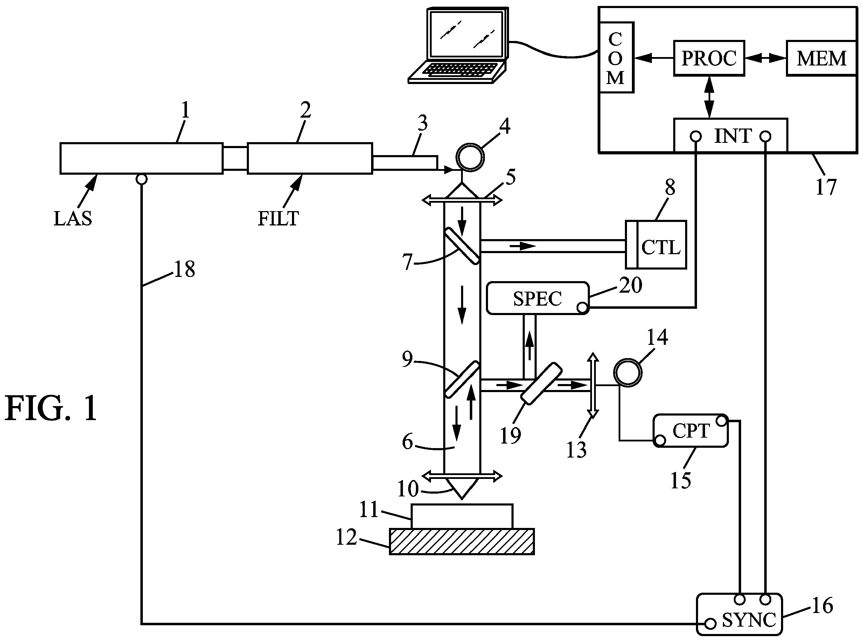

Comme on le verra dans l'exemple de réalisation décrit ci-après en référence à la figure 1, il peut être avantageux de prévoir un module pour synchroniser le comptage de photons (pour la mesure de luminescence) aux impulsions du laser (module 16 de la figure 1).

La présente invention vise aussi un programme informatique comportant des instructions au moins pour l'estimation de la densité de défauts ($\Psi_D$) dans le matériau de la couche mince, pour la mise en oeuvre du procédé ci-avant, lorsque ce programme est exécuté par un processeur.

Ce programme informatique peut comporter en outre des instructions pour l'estimation de la tension de circuit ouvert maximale ($\Delta\mu$) du matériau de la couche mince, lorsque ce programme est exécuté par un processeur.

Ainsi, l'invention propose notamment un procédé permettant d'effectuer une mesure sans contact de défauts jouant le rôle de pièges pour les porteurs de charges dans une cellule photovoltaïque en couche mince. L'invention permet aussi de tracer quantitativement la distribution énergétique de ces défauts, lesquels peuvent avoir différents niveaux énergétiques au sein du matériau photovoltaïque. Il est plus généralement proposé ici une technique quantitative liée directement à la performance photovoltaïque du photorécepteur. En effet, non seulement le procédé permet de quantifier les pièges et de les localiser, mais aussi de quantifier leur effet sur la performance photovoltaïque globale du photorécepteur.

D'autres avantages et caractéristiques de l'invention apparaîtront à la lecture de la description détaillée ci-après d'exemples de réalisation de l'invention, et à l'examen des dessins annexés sur lesquels :

- la figure 1 illustre un exemple de dispositif pour la mise en oeuvre de l'invention,

- la figure 2 illustre l'évolution énergétique de la valeur absolue de pièges électroniques dans le matériau photovoltaïque,

- la figure 3 illustre la tension de circuit ouvert maximale en fonction de la densité de pièges électroniques,

- la figure 4 illustre une mise en oeuvre du dispositif de la figure 1 dans une ligne de production de cellules photovoltaïques,

- la figure 5 illustre une mise en oeuvre du dispositif de la figure 1 pour une analyse cartographique d'échantillons de cellules photovoltaïques,

- la figure 6 est une cartographie de la densité de pièges électroniques résultant de la mise en oeuvre du dispositif de la figure 5,

- la figure 7 est une cartographie des pertes absolues en performance photovoltaïque, correspondant à la cartographie de la figure 6,

- la figure 8 illustre schématiquement la dynamique des porteurs de charges,

- les figures 9A et 9B illustrent respectivement la reconstruction du déclin de luminescence résolu en temps et l'évolution de l'erreur de reconstruction en fonction de densités de défauts $\Psi_D$ successivement choisies,

- la figure 10 illustre la densité de pièges électroniques en fonction du flux de photons incidents,

- la figure 11 représente l'intensité totale de luminescence en fonction de la densité de pièges électroniques sous différentes longueurs d'ondes d'excitation lumineuse.

## Structure d'un dispositif au sens de l'invention

Sur la figure 1, la référence 1 désigne un laser émettant de la lumière blanche, par impulsions (appelé ci-après laser pulsé blanc). La référence 2 désigne un filtre de longueurs d'onde. La référence 3 désigne le faisceau laser émis. La référence 4 désigne une fibre optique. La référence 5 désigne une lentille plan-convexe. La référence 6 désigne un objectif de microscope dans l'exemple représenté. La référence 7 désigne une pellicule de séparation de faisceau. La référence 8 désigne une diode de contrôle. La référence 9 désigne un miroir dichroïque. La référence 19 désigne une lame séparatrice (50-50). La référence 20 désigne un spectromètre relié à un circuit de traitement informatique 17. La référence 13 désigne une lentille convergente. La référence 14 désigne une fibre optique. La référence 15 désigne un compteur de photons. La référence 16 désigne un synchronisateur optoélectronique. La référence 10 désigne un faisceau de focalisation sur un échantillon 11 (par exemple une couche mince photovoltaïque déposée sur un substrat) et la référence 12 désigne un porte-échantillon. Enfin, la référence 18 désigne un câble de connexion pour une commande du laser pulsé.

Ainsi, le dispositif de l'invention prévoit l'utilisation d'une source de laser pulsé 1. La fréquence des impulsions laser (ou « pulses ») est réglable et peut atteindre une valeur de 80 MHz. Dans le cadre de cette invention, la fréquence laser utilisée est par exemple de 20 MHz. Le laser blanc possède des longueurs d'onde qui s'étendent de 450 nanomètres jusqu'à 1600 nanomètres. Cette particularité du laser utilisé est un avantage dans l'invention dans son application à la caractérisation de cellules solaires pour leur propriété à la conversion de la lumière solaire.

En pratique, le filtre 2 à laser blanc commandé informatiquement permet de sélectionner une longueur d'onde souhaitée. En variant cette longueur d'onde à la sortie du filtre, il est possible d'accéder optiquement à la distribution des pièges électroniques au sein du matériau photovoltaïque. Le faisceau laser 3 est ensuite couplé à l'intérieur d'une fibre optique 4. A la sortie de la fibre optique, la lentille 5 collimate le faisceau laser. Une partie du faisceau est transmise par la lame séparatrice 7 à un capteur de contrôle de fluctuation 8.

La lame séparatrice 9, adaptée à la transmission du faisceau incident et à la réflexion du spectre émis, est placée dans le chemin optique. Le faisceau d'excitation est focalisé sur l'échantillon 11 par l'intermédiaire d'un élément optique adapté, par exemple une lentille convergente ou bien un objectif de microscope 6. La taille du spot créé dépend de l'ouverture numérique de cet élément, de sa pupille d'entrée, du diamètre du faisceau et de la longueur d'onde du faisceau.

Le laser pulsé et focalisé excite ainsi la cellule solaire 11 posée sur un porte-échantillon 12 apte à se déplacer selon les axes X et Y dans le plan perpendiculaire au faisceau. L'objectif du microscope 6 peut lui-même se déplacer relativement à l'échantillon selon l'axe Z pour sonder une couche ou un empilement de couches minces en profondeur ou en superficie. En effet, l'échantillon peut être une cellule solaire en couches minces dont l'absorbeur photovoltaïque peut être formé d'un quaternaire de cuivre, indium, gallium et sélénium (CIGS), avec une épaisseur d'environ 2 micromètres.

### *Effets de la mise en oeuvre du dispositif selon l'invention et résultats obtenus*

Une fois excitée par le laser pulsé, la cellule solaire se trouve dans un état de déséquilibre.

La cellule solaire se débarrasse de cet état de déséquilibre en émettant de la lumière (luminescence des cellules solaires et plus généralement des photorécepteurs semiconducteurs). En particulier, le faisceau laser d'excitation excite les électrons dans la bande de valence du semiconducteur, ces derniers se trouvant à l'état excité dans la bande de conduction.

Ensuite, ces électrons se relaxent et se recombinent avec des trous (lacunes de charges positives) se trouvant dans la bande de valence. Cette relaxation est accompagnée par une émission de lumière où les photons possèdent une énergie égale au « gap » du semiconducteur (largeur de bande interdite). Ces recombinaisons radiatives sont à l'origine du signal de luminescence.

L'invention se base sur ce signal et sa variation temporelle pour remonter à la densité des pièges de porteurs de charges au sein de la cellule solaire.

L'absorbeur de la cellule solaire possède par exemple une énergie du gap autour de 1,13 électrons-volts (eV). La luminescence fournit un signal dont la longueur d'onde se trouve dans le domaine du proche infrarouge. La lame de séparation 9 réfléchit ainsi le signal de luminescence émis par la cellule solaire. La lame séparatrice 19 divise le signal de luminescence en deux signaux ayant chacun la moitié de l'intensité du signal initial. La première moitié est renvoyée vers un spectromètre 20 réalisant une acquisition du spectre de luminescence et un enregistrement informatique dans le circuit de traitement 17.

Le circuit de traitement informatique 17 comporte un processeur PROC et une mémoire MEM de stockage des codes d'instructions d'un programme informatique pour la mise en oeuvre du procédé de l'invention, et de données de mesures et/ou temporaires, et une interface INT de réception des signaux de mesure. Le processeur PROC peut être relié à une interface graphique COM pour visualiser des paramètres tirés des mesures, tels que la densité de défauts et/ou la tension de circuit ouvert maximale $\Delta\mu$, par exemple sous forme de cartographies respectives prises en différents points de l'échantillon.

La deuxième moitié du signal de luminescence est couplé grâce à la lentille convergente 13 dans une fibre optique de collection 14 transmettant efficacement les signaux infrarouges.

La sortie de la fibre optique de collection est à son tour connectée à un compteur de photons « uniques » 15 (avec une précision d'un comptage de photons, un par un), sensible aux longueurs d'onde dans l'infrarouge. L'excitation par faisceau laser étant pulsée, il est alors possible de résoudre temporellement le signal de luminescence émis par la cellule solaire. Le compteur de photons uniques est capable de transformer le signal optique de luminescence à son entrée en un signal électrique à sa sortie.

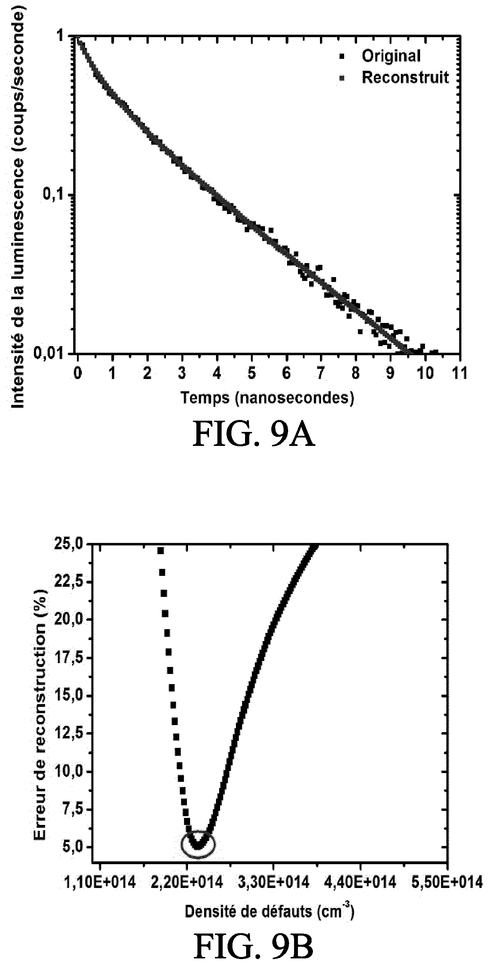

Ensuite, ce signal électrique et celui des trains d'impulsions laser sont fournis en entrée du circuit de traitement 17 pour synchroniser ces deux signaux. En particulier, cette synchronisation permet d'établir un histogramme qui traçant l'arrivée des photons issus de luminescence sur le compteur de photons uniques, en fonction du temps. On obtient finalement l'évolution temporelle de l'intensité de luminescence exprimée en nombre de coups par seconde (figure 9A commentée plus loin). Cette variation est ensuite enregistrée.

L'analyse de l'évolution de l'intensité de luminescence en fonction du temps permet d'évaluer la dynamique des porteurs de charges une fois générés sous l'effet du laser pulsé incident. Dans un semi-conducteur parfait et en l'absence de collecte de charges électriques, le nombre exact de photons incidents est récupéré par recombinaisons purement radiatives au niveau du signal de luminescence détecté. Néanmoins, un photorécepteur semiconducteur réel, tel qu'une cellule solaire à base d'absorbeur tel que par exemple CIGS, ne correspond à ce cas idéal. En réalité, les porteurs de charges générés sous excitation laser empruntent deux voies possibles :

- soit, ils se recombinent directement de manière radiative avec les trous de la bande de valence,

- soit, ils sont piégés par la densité de défauts non nulle au sein du matériau photovoltaïque.

Ainsi, grâce à l'évolution de l'intensité de la luminescence en fonction du temps, il est possible de savoir de manière qualitative laquelle des deux voies a été empruntée majoritairement par ces porteurs de charges et par conséquent décrire qualitativement l'effet de la densité de défauts sur la dynamique des porteurs, et finalement sur la performance de la cellule solaire.

Il est proposé en outre au sens de l'invention de quantifier cette densité de pièges notée $\Psi_D$ exprimée en *$cm^{-3}$*. En pratique, la résolution d'un système d'équations différentielles présenté ci-après permet de représenter et prendre en compte les phénomènes physiques précédemment décrits. Une résolution numérique de ce système d'équations permet de reconstruire avec une grande précision les signaux de luminescence résolus en temps. L'application de l'invention permet d'obtenir des erreurs de reconstruction inférieures à 7% sur l'ensemble des points du signal. Une fois que la reconstruction la plus optimale est atteinte, la valeur de la densité de pièges électroniques au sein du matériau photovoltaïque étudié peut alors être déterminée. En parallèle, l'analyse du spectre de luminescence acquis simultanément avec le signal de luminescence résolu en temps permet d'extraire aussi la valeur de $\Delta\mu$ correspondante, comme on le verra en détails ci-après.

### Quantification de la densité de pièges électroniques

L'étude de la dynamique des porteurs au sein du matériau photovoltaïque en couches minces permet d'observer l'évolution temporelle de trois populations différentes d'électrons:

- La population $N_1$ correspondant au nombre d'électrons dans la bande de valence,

- La population $N_2$ correspondant au nombre d'électrons piégés par la densité d'états accessible des défauts,

- La population $N_3$ correspondant au nombre d'électrons dans la bande de conduction.

Le niveau énergétique de la bande de conduction est noté $E_c$ et celui de la bande de valence est noté $E_v$. La différence entre les deux énergies est égale à l'énergie du gap du semiconducteur.

Les électrons photo-générés peuvent se recombiner directement avec les trous dans la bande de valence émettant ainsi un signal de luminescence. Le temps moyen au bout duquel ces électrons sont dans la bande de conduction avant leur recombinaison avec les trous, en l'absence de défauts, est représenté par leur temps de vie de recombinaison bande-à-bande $\tau_{Rec}$. Ces électrons, une fois présents dans la bande de conduction, peuvent être alternativement capturés par les pièges électroniques existants. La densité de ces pièges est notée $\Psi_D$ et le temps pendant lequel ces électrons se retrouvent dans la bande de conduction avant leur capture est représenté par le temps de vie de capture $\tau_{Cap}$. Après leur capture, les électrons peuvent être à nouveau libérés des pièges par des phénomènes d'émission auxquels on associe un temps de vie d'émission $\tau_{Cap}$. Le calcul des temps de vie d'émission et de capture dépend des propriétés des défauts qui jouent le rôle de pièges. Ces derniers possèdent une distribution de leurs niveaux énergétiques à proximité de la bande de valence s'il s'agit de défauts accepteurs, ou à proximité de la bande de conduction s'il s'agit de défauts donneurs. Dans l'application de l'invention, une distribution énergétique gaussienne de ces défauts peut être considérée à proximité de la bande de conduction. Il est à noter que le cas de défauts accepteurs est également envisageable en variante.

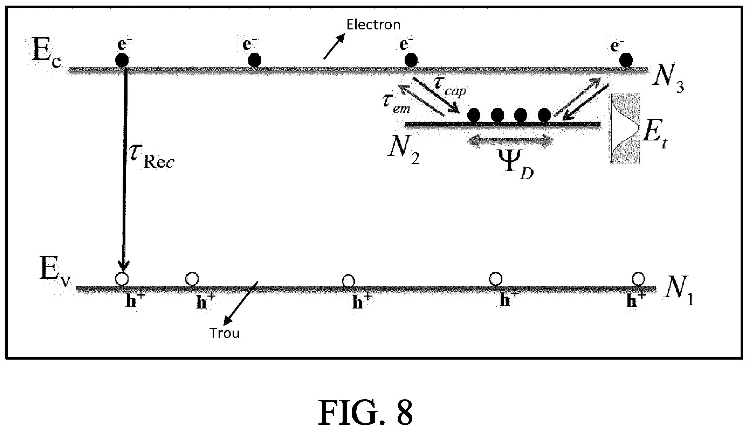

Il peut donc être proposé un système d'équations différentielles décrivant l'évolution temporelle de ces trois populations et illustrées sur la figure 8 :

$$\begin{cases} \dfrac{dN_1}{dt} = +\dfrac{N_3}{\tau_{Rec}} - G(t = \tau_p) \\[2mm] \dfrac{dN_2}{dt} = \left(1 - \dfrac{N_2}{\Psi_D}\right)\left(\dfrac{N_3}{\tau_{Cap}}\right) - \left(\dfrac{N_2}{\tau_{em}}\right) \\[2mm] \dfrac{dN_3}{dt} = \dfrac{N_2}{\tau_{em}} - \left(1 - \dfrac{N_2}{\Psi_D}\right)\left(\dfrac{N_3}{\tau_{Cap}}\right) - \left(\dfrac{N_3}{\tau_{Rec}}\right) + G(t = \tau_p) \end{cases}$$

Ce système d'équations explique l'origine de la luminescence résolue en temps lors de la mise en oeuvre du dispositif de la figure 1.

Dans un premier exemple de réalisation, pour la caractéristique d'une couche photovoltaïque par exemple à base de CIGS, on peut sélectionner une longueur d'onde laser égale à 700 *nm*.

Chaque impulsion de laser utilisé dans l'exemple décrit ici possède une largeur à mi-hauteur $\tau_p$ de 6 picosecondes et une puissance crête $P_0$ égale à 25 milliwatts. Pour formaliser cette impulsion, la puissance incidente du laser pulsé peut être déterminée par:

$$P(t) = \frac{P_0}{\left(\cosh\left(\dfrac{t}{\tau_p}\right)\right)^2}$$

A partir de cette relation, et comme la réflexion du matériau à la longueur d'onde du laser utilisée $R(\lambda = 700nm)$ est connue, le nombre exact d'électrons générés par cette impulsion laser peut être calculé comme suit : $\phi(t) = \dfrac{\lambda P(t)}{hc}$, $\lambda$ étant la longueur d'excitation.

$$G = \frac{1 - R(\lambda = 700nm)}{\Gamma(\lambda = 700nm)} \int_0^{\tau_p} \phi(t)dt$$

où R ($\lambda$=700 *nm*) est le coefficient de réflexion à cette longueur d'onde $\lambda$ du matériau analysé et

$\Gamma$($\lambda$=700 nm) est la profondeur de photo-pénétration à cette longueur d'onde $\lambda$ (par exemple de l'ordre de 1 $\mu$m).

Selon le système d'équations précédent, la population $N_1$ diminue au moment de l'excitation laser. Cette diminution est relative à la quantité d'électrons photo-générés depuis la bande de conduction. Au cours du temps, $N_1$ augmente de nouveau grâce aux évènements de recombinaisons de bande-à-bande. La population $N_2$ présente dans les pièges augmente par l'intermédiaire des évènements de capture des électrons de la bande de conduction (à condition que la fonction d'occupation de l'ensemble des défauts soit supérieure à 0, bien entendu). D'autre part, $N_2$ diminue aussi à cause des évènements d'émission des pièges vers la bande de conduction. Préalablement, au moment de l'excitation laser, la population $N_3$ gagne la quantité d'électrons photo-générés. Son évolution est l'inverse de celle de $N_2$. En revanche, $N_3$ diminue également par recombinaisons bande-à-bande.

Le calcul des temps de vie de capture et d'émission des défauts se calcule selon la relation suivante :

$$\begin{cases} \dfrac{1}{\tau_{em}} = \sigma_e v_{th} N_c \exp\left(-\dfrac{E_t}{kT}\right) \\ \dfrac{1}{\tau_{cap}} = \Psi_D \sigma_e v_{th} \end{cases}$$

Cette formule considère que les électrons sont émis des pièges par voie thermique. Ces derniers possèdent une vitesse thermique $v_{th}$. De plus, la valeur du temps de vie d'émission dépend de la section efficace de capture des pièges $\sigma_e$, leur densité $\Psi_D$ et leur distribution énergétique $E_t$ qui est gaussienne dans le présent cas. D'autres formules sont envisageables selon le matériau utilisé et les conditions expérimentales, ou un modèle choisi pour représenter le comportement physique de ses défauts. Par exemple, il peut être inclus dans le système d'équations différentielles une transition entre le niveau N2 et le niveau N1, caractérisé par un temps de transition propre. Les temps d'émission et de capture peuvent être choisis différents, selon des formules classiques issues de la littérature ou bien selon une physique spécifique au matériau étudié et aux conditions expérimentales.

La seule variable véritablement inconnue du système d'équations est la densité de pièges $\Psi_D$.

Par la suite, on cherche à faire varier cette densité uniquement. Pour chaque valeur de $\Psi_D$, le système d'équations est résolu en utilisant par exemple la méthode de Runge-Kutta d'ordre 4. Chaque solution fournit une décroissance de la luminescence en fonction du temps, puis comparée au déclin de luminescence observé par les mesures réalisées par le dispositif de la figure 1. Les deux courbes sont comparées point par point. Ceci est fait pour l'ensemble des valeurs de $\Psi_D$ choisies. La solution qui résulte en la meilleure reconstruction des données mesurées est donc retenue, fournissant ainsi la valeur de la densité de défauts du matériau étudié.

On a illustré sur la figure 9A la reconstruction du déclin de luminescence résolue en temps de mesure. Il est alors possible, en référence à la figure 9B d'identifier le minimum d'erreur de reconstruction donnant la densité de défauts la plus probable dans le matériau photovoltaïque analysé. L'optimisation de la reconstruction du déclin de luminescence résolue en temps a résulté en une erreur de reconstruction globale de l'ordre de 5% et la densité de défauts dans le matériau résultante est ici de $2,3 \times 10^{14}$ pièges/cm$^3$.

Il apparait donc que la mise en oeuvre de l'invention permet de caractériser finement la densité de pièges et ce avec un niveau d'erreur bas.

### *Quantification de la tension de circuit ouvert maximale $\Delta\mu$*

En outre, l'analyse du spectre de luminescence (variation du signal de luminescence en fonction de la longueur d'onde, montrant un pic maximum à la longueur d'onde du gap) permet d'extraire, en utilisant la loi de Planck généralisée, la valeur de l'espacement des quasi-niveaux de Fermi de la cellule solaire. Cet espacement noté $\Delta\mu$ est exprimé en électronvolts (eV) et se mesure avec la pente du front montant (longueurs d'ondes croissantes) du pic de luminescence. Physiquement, $\Delta\mu$ représente la tension de circuit ouvert maximale de l'échantillon photovoltaïque à laquelle on peut s'attendre.

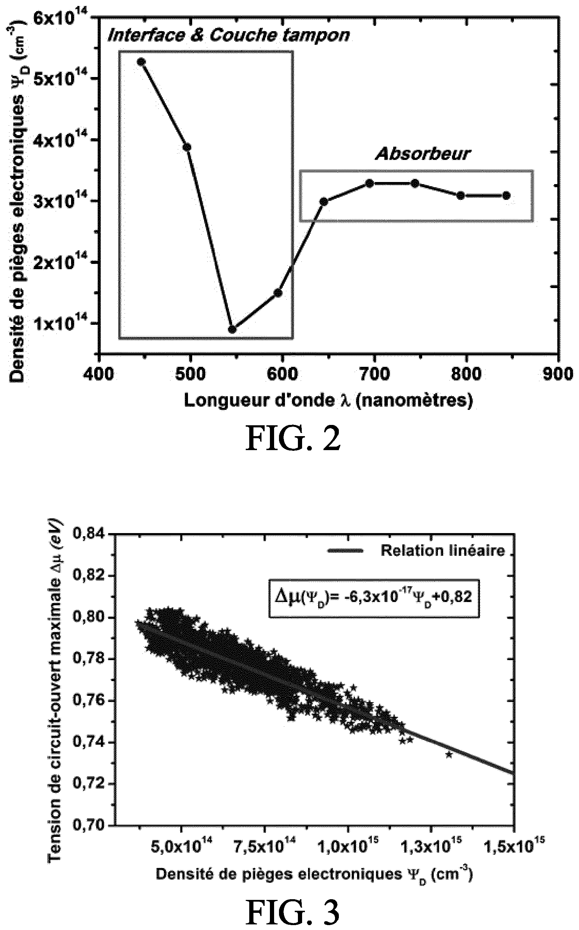

Il s'est avéré qu'une mesure simultanée de la densité de défauts $\Psi_D$ et de la grandeur $\Delta\mu$ montre que pour chaque énergie donnée (ou longueur d'onde d'éclairement de l'échantillon pour provoquer la luminescence), un couple de valeurs $\{\Psi_D, \Delta\mu\}$ peut être déterminé, avec une corrélation directe entre les valeurs $\Delta\mu$ et $\Psi_D$ de ce couple. En effet, les variations des valeurs de tension de circuit ouvert maximale d'une cellule solaire $\Delta\mu$ sont fortement liées à celles de la densité de pièges électroniques comme illustré sur la figure 3.

En particulier, il apparait une relation linéaire entre les grandeurs $\Psi_D$ et $\Delta\mu$. Une augmentation de la densité de pièges électroniques entraine une chute linéaire de la tension de circuit ouvert maximale de la cellule solaire. Ainsi, il est possible de vérifier directement à l'aide de la valeur de la densité $\Psi_D$ les valeurs de $\Delta\mu$ qui peuvent être mesurées depuis la variation spectrale de luminescence.

De plus, en exploitant cette linéarité et en l'extrapolant à une situation idéale caractérisée par une absence de pièges, il est possible de déterminer un gain en tension de circuit ouvert théorique dans un matériau idéal de composition donnée (pour CIGS avec variation des proportions In/Ga et/ou S/Se, ou encore dans CdTe, etc.). Dans l'exemple de matériau de la figure 3, ce gain présente une hausse de 25% de la tension de circuit-ouvert du dispositif photovoltaïque.

Il est donc possible de déterminer pour différents types de matériaux, la tension de circuit-ouvert maximale théorique et de déterminer s'il serait utile pour certains matériaux de chercher à parfaire leur condition de croissance pour limiter la présence de pièges.

En outre, il est possible de déterminer quantitativement la performance photovoltaïque de l'échantillon analysé car, non seulement il est possible de quantifier les pièges et de les localiser mais il est possible aussi de quantifier leur effet sur la performance photovoltaïque globale de l'échantillon photovoltaïque analysé.

### *Quantification pour des empilements de couches minces*

Ces opérations peuvent être répétées pour plusieurs longueurs d'onde de laser choisies. En changeant la longueur d'onde du laser, il est possible de sonder et quantifier des pièges de plus en plus profonds énergétiquement. Les longueurs d'ondes sélectionnées peuvent typiquement s'étendre de 450 nanomètres à 850 nanomètres, pour couvrir toute la partie visible du spectre solaire.

Par exemple pour le cas d'une couche de CIGS, sur laquelle est déposée une couche tampon classique de sulfure de cadmium CdS, l'absorbeur du matériau photovoltaïque possède une énergie de gap égale à 1,14 *eV* et la couche tampon possède une énergie de gap de 2,4 *eV*. Les longueurs d'onde sélectionnées permettent de quantifier et de tracer la distribution des pièges électroniques dans trois zones clés de l'empilement :

- l'absorbeur,

- l'interface absorbeur/couche tampon et

- une partie de la couche tampon.

En référence à la figure 2, il est possible de tracer de manière quantitative la distribution énergétique des pièges électroniques au sein du matériau photovoltaïque étudié, et, de plus, de distinguer la localisation spatiale des pièges sondés en fonction de l'énergie de la longueur d'onde étudiée. On distingue alors la densité des pièges dans l'absorbeur de leur densité présente à l'interface entre l'absorbeur et la couche tampon. Cette distinction est un autre avantage obtenu par la mise en oeuvre de l'invention qui permet d'étudier distinctement et sans contact les différentes couches de l'empilement photovoltaïque.

*Exemples de réalisation et application industrielle*

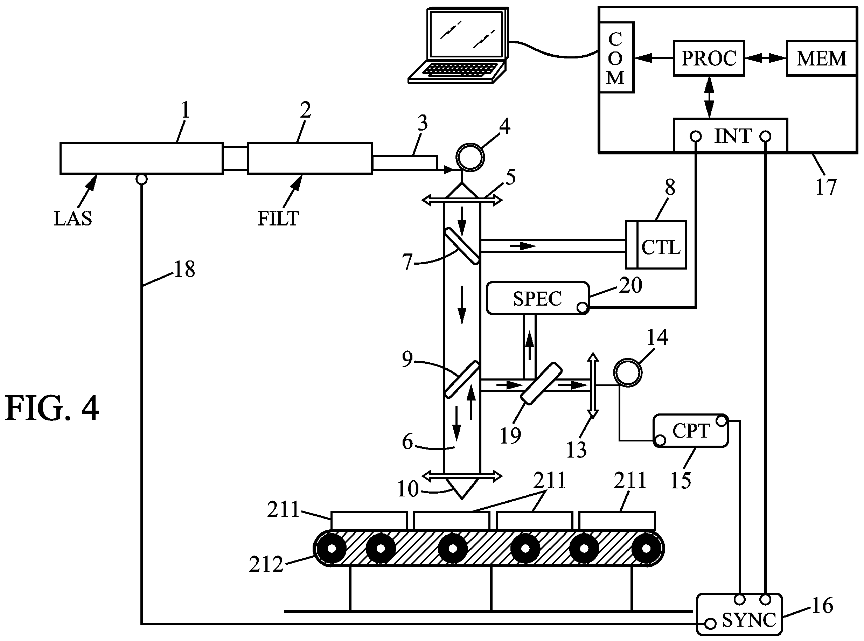

L'invention peut être mise en oeuvre notamment dans une ligne de production de panneaux solaires photovoltaïques. Dans le mode de réalisation illustré sur la figure 4 ci-dessous, les mêmes éléments que la figure 1 portent les mêmes références et ne sont pas décrits encore ci-après. Ici, l'implémentation de l'invention dans une ligne de production 212 de panneaux photovoltaïques 211 suit le mode opératoire suivant.

Suite au dépôt de la couche de l'absorbeur photovoltaïque, chaque échantillon produit fait l'objet des analyses détaillées ci-avant et présentées sur les figures 2 et 3. Par exemple, trois analyses peuvent être effectuées sur l'ensemble des échantillons avant que ces derniers ne passent à une étape suivante de fabrication visant le dépôt de la couche tampon. Le choix de passer à la prochaine étape de dépôt peut dépendre des résultats des trois analyses qualitatives, statistiques et quantitatives ci-après.

Sur chaque échantillon, on vérifie qu'il respecte les trois critères ci-après :

- Selon un premier critère, l'évolution de la valeur absolue de densité de pièges $\Psi_D$ en fonction de l'énergie (figure 2), et une mesure en parallèle du $\Delta\mu$, sont effectuées. Une analyse statistique sur l'ensemble des échantillons permet d'évaluer la répétabilité des propriétés de dépôt de l'absorbeur, laquelle est reflétée par l'importance du changement du comportement de $\Psi_D$ en fonction de l'énergie, d'un échantillon à un autre. Pour chaque énergie donnée, on calcule aussi une distribution gaussienne des valeurs $\Psi_D$ relevées sur l'ensemble des échantillons produits. Des critères de suivi de la qualité permettent ainsi d'écarter des produits non conformes du flux de production ;

- Selon un deuxième critère, dans le cas où le premier critère est satisfait, la longueur d'onde d'étude est fixée à 700 *nm* par exemple et $\Psi_D$ est calculée pour trois points de mesure différents sur l'échantillon, afin d'établir la linéarité entre $\Psi_D$ et $\Delta\mu$ selon la figure 3. De cette linéarité on quantifie les pertes en tension de circuit ouvert maximale $\Delta\mu$ causée par les valeurs de $\Psi_D$ pour chaque absorbeur analysé. Une étude statistique est établie sur l'ensemble des pertes. Ce deuxième critère permet là encore d'écarter les produits non conformes ;

- Selon un troisième critère, dans le cas où les deux critères précédents sont satisfaits, les échantillons passent à une étape de fabrication suivante consistant au dépôt de la couche tampon. A ce stade, les mêmes mesures sont faites à nouveau et les mêmes premier et deuxième critères de passage sont appliqués, afin cette fois d'évaluer qualitativement et quantitativement l'interface entre l'absorbeur et la couche tampon. De nouvelles informations peuvent alors être tirées telle que l'influence du dépôt de la couche tampon sur les valeurs et l'évolution de $\Psi_D$ en fonction de l'énergie pour les régions propres à l'absorbeur, ainsi que pour les régions qui sont propres à l'interface. Cette influence peut être quantifiée en termes de pertes en $\Delta\mu$.

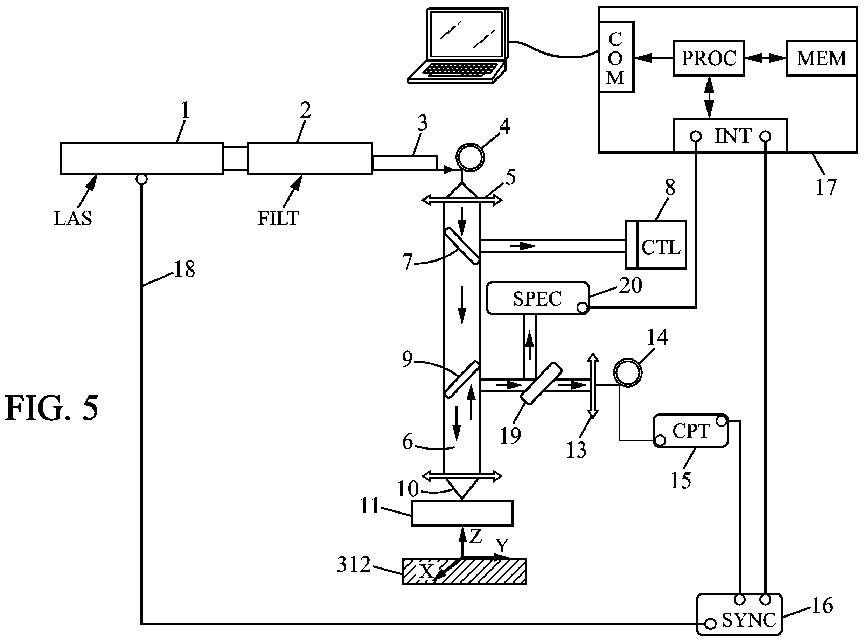

Dans le cas où une analyse plus approfondie des cellules photovoltaïques fabriquées est souhaitée, il est possible en outre d'établir une cartographie à l'échelle micrométrique de la densité de pièges électroniques au sein de la cellule en couches minces. Le mode de réalisation correspondant est illustré sur la figure 5 commentée ci-après (et sur laquelle les mêmes éléments que sur la figure 1 portent les mêmes références).

Lorsqu'une plateforme piézoélectrique 312 est ajoutée au montage de la Figure 1, il est possible de balayer la totalité de la cellule solaire avec des pas de l'ordre de quelques centaines de nanomètres. Pour chaque pas effectué, le couple $\{\Psi_D, \Delta\mu\}$ est simultanément calculé comme précédemment présenté.

Pour une longueur d'onde d'excitation fixée à 700 nanomètres par exemple, le résultat final est une cartographie de $\Psi_D$ et une cartographie de $\Delta\mu$ obtenues avec une résolution spatiale micrométrique. L'utilité d'une telle application est d'examiner avant tout la densité locale de pièges, et ensuite évaluer ses fluctuations spatiales. Cette information spatiale supplémentaire permet d'évaluer l'homogénéité spatiale des propriétés du matériau photovoltaïque et d'identifier les régions qui souffrent d'une importante densité de pièges. On peut donc quantifier spatialement la distribution des pertes en performance photovoltaïque. Les zones causant de hautes pertes de performance sont identifiées afin d'envisager une optimisation des conditions de dépôt de couches minces pour ces zones défectueuses en particulier.

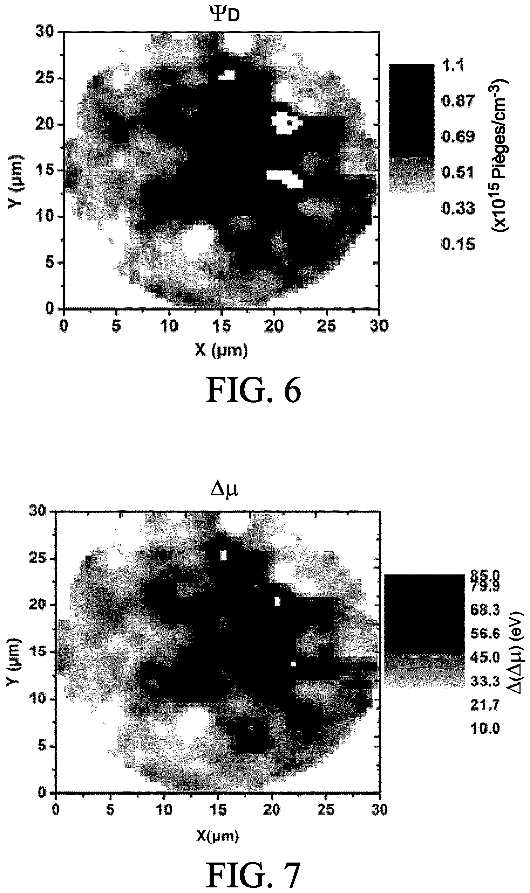

On a représenté sur les figures 6 et 7 un exemple de cartographies micrométriques de $\Psi_D$ obtenues sur une microcellule de composition Cu(In,Ga)Se$_2$ et de diamètre égale à 30 micromètres. En se basant sur la cartographie de $\Psi_D$ de la figure 6 et la relation de linéarité $\{\Psi_D, \Delta\mu\}$ de la figure 3, la cartographie des pertes en tension de circuit-ouvert maximale peut être obtenue sur la figure 7.

Les cartographies obtenues peuvent être calculées pour toute la plage de longueur d'onde du visible, ce qui permet de quantifier l'effet du dépôt de chaque couche de l'empilement photovoltaïque sur l'inhomogénéité spatiale de la performance photovoltaïque globale et les densités de pièges électroniques correspondant.

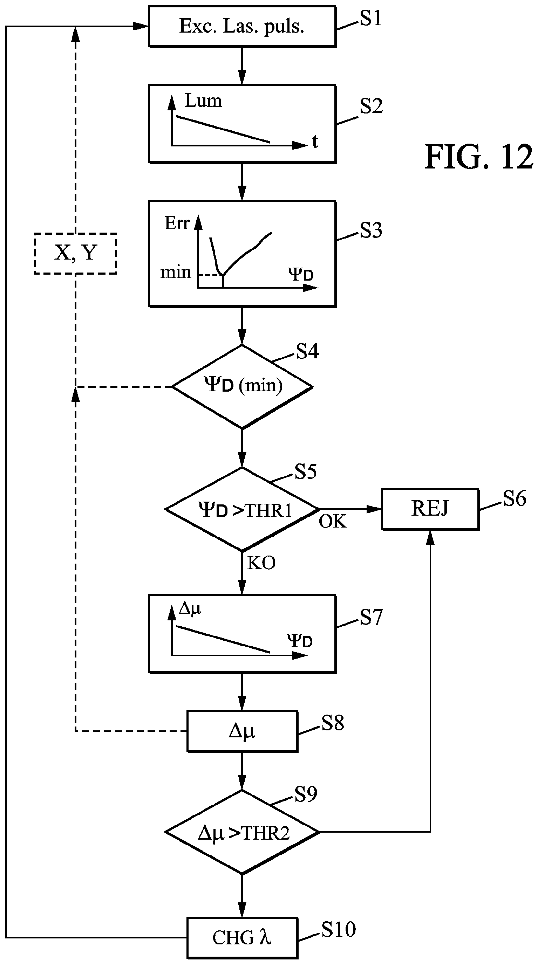

On a résumé sur la figure 12 les différentes étapes qui peuvent être mises en oeuvre dans le cadre d'un procédé au sens de l'invention. À l'étape S1, le laser pulsé excite l'échantillon (par exemple une couche à propriétés photovoltaïques déposée sur un substrat). Il est recueilli un signal de luminescence (naturellement décroissant en fonction du temps) sur l'ensemble du spectre ou seulement à une ou plusieurs longueurs d'onde d'observation données (en utilisant par exemple un filtre passe-bande étroit pour le filtrage spectral du signal de luminescence), et on détermine en particulier un profil de décroissance de ce signal à l'étape S2, lequel est fonction de la densité des défauts. À l'étape S3, ce profil de décroissance est reconstruit à l'aide de différentes valeurs de densité de défauts $\Psi_D$, selon le modèle de résolution du système à trois équations différentielles présentées ci-avant. En particulier, il est recherché la densité de défauts $\Psi_D$ qui minimise l'erreur de reconstruction. Il est alors déterminé cette densité de défauts $\Psi_D$ (min) à l'étape S4. Ces étapes peuvent être répétées en plusieurs points de l'échantillon de manière à obtenir une cartographie de la densité de défauts (répétitions illustrées par des traits pointillés sur la figure 12), optionnellement. Pour la densité de défauts $\Psi_D$ (min) identifiée à l'étape S4, il peut être prévu à l'étape S5 une comparaison à un seuil THR1 (par exemple $10^{15}$ défauts par cm$^3$ pour du CIGS) et si la densité de défauts est supérieure à ce seuil, de rejeter à l'étape S6 un échantillon comme non valide dans le cadre d'un contrôle qualité dans une chaîne de production.

Sinon, à l'étape S7, il peut être déterminé en outre une valeur certaine de la tension de circuit ouvert maximale $\Delta u$, par corrélation selon une relation linéaire avec la densité de défauts $\Psi_D$. Cette valeur de la tension de circuit ouvert maximale $\Delta\mu$ est « certaine » en ce sens qu'elle n'est pas simplement mesurée sur les spectres de luminescence, mais elle est réellement corrélée à la densité des défauts et ainsi l'influence de la densité de défauts $\Psi_D$ est réellement prise en compte dans la détermination de la valeur de la tension de circuit ouvert maximale $\Delta\mu$ qui est obtenue à l'étape S8. Ces étapes peuvent optionnellement être répétées aussi en plusieurs points de l'échantillon de manière à obtenir une cartographie de la densité de défauts (traits pointillés sur la figure 12).

La valeur de la tension de circuit ouvert maximale $\Delta\mu$ obtenue à l'étape S8 peut être comparée à un deuxième seuil THR2 (par exemple 0,75 eV pour du CIGS) à l'étape S9, et si cette valeur est inférieure à ce seuil THR2, il peut être prévu de rejeter à l'étape S6 un échantillon comme non valide dans le cadre d'un contrôle qualité dans une chaîne de production.

Sinon, à l'étape S10, il peut être choisi une nouvelle longueur d'onde d'excitation, inférieure à celle du gap d'une autre couche dans un empilement comprenant la couche photovoltaïque étudiée précédemment. Le but peut être d'étudier cette autre couche de l'empilement ou encore d'étudier par exemple l'interface entre la couche photovoltaïque et cette autre couche et notamment la densité de défauts à l'interface. Dans ce cas, les étapes S1 à S9 peuvent être réitérées pour cette autre étude comme présenté ci-dessus en référence à la figure 2.

### Flexibilité des mesures au sens de l'invention

Il est possible de choisir les propriétés de l'excitation lumineuse qui conviennent le plus à un échantillon donné sans que ceci n'affecte les résultats de mesure fournis.

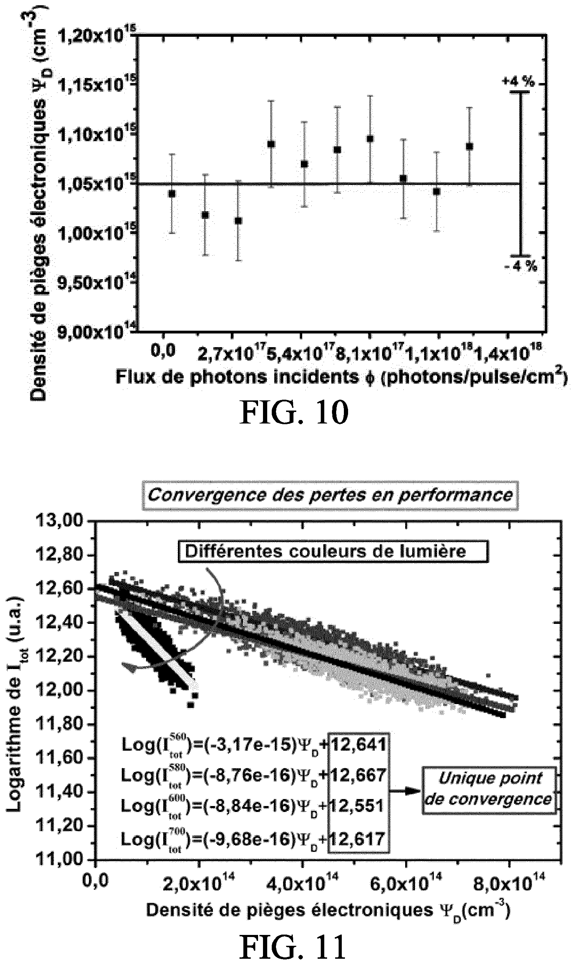

Par exemple, il est possible de changer la puissance d'excitation lumineuse comme désiré. Un calcul de densité de pièges électroniques au sein du même matériau photovoltaïque, en variant la puissance d'excitation lumineuse, a été effectué comme illustré sur la figure 10 et il apparait que les changements de puissance d'excitation lumineuse ne modifient pas la détermination de la densité de pièges mesurée.

Sur la figure 10, la valeur de flux de photons incidents choisie n'a pas d'incidence sur les résultats, lesquels sont monotones (constants avec des fluctuations de l'ordre de $\pm$ 4% par rapport à la valeur moyenne de l'ensemble des mesures). Ces fluctuations, faibles, sont satisfaisantes et montrent la fiabilité du dispositif de l'invention.

Par ailleurs, comme présenté ci-avant, il apparait une relation linéaire entre la tension de circuit ouvert maximale $\Delta\mu$ et la densité des pièges $\Psi_D$ dans le matériau photovoltaïque. Il peut être extrait de cette linéarité la perte potentielle en tension induite par $\Psi_D$. Dans l'exemple ci-avant, une seule longueur d'onde d'excitation égale à 700 nm a été utilisée. Néanmoins, il a été vérifié si des pertes différentes pouvaient être mesurées lorsque la longueur d'onde est changée. La relation entre $\Delta\mu$ et $\Psi_D$ de la figure 3 a été établie pour trois autres longueurs d'onde : 600 nm, 580 nm et 560 nm.

La surface balayée par le déclin de luminescence en fonction de temps constitue l'intensité totale de luminescence émise par le matériau photovoltaïque pendant ce déclin. La loi de Planck généralisée relie directement l'intensité de luminescence émise aux propriétés optiques du matériau photovoltaïque. En particulier, cette loi montre que l'intensité de luminescence est exponentiellement reliée à la tension de circuit ouvert maximale $\Delta\mu$. Donc, en traçant le logarithme de l'intensité totale du déclin de luminescence résolu en temps Itot en fonction de la densité de pièges $\Psi_D$, aux différentes longueurs d'ondes précédentes, comme illustré sur la figure 11, le comportement de $\Delta\mu$ en fonction de $\Psi_D$ à différentes longueurs d'ondes est donné par extrapolation comme suit.

Déjà, il apparait encore une linéarité entre la tension de circuit-ouvert maximale $\Delta\mu$ et les densités de pièges à différentes longueurs d'ondes. En outre, pour une quelconque longueur d'onde utilisée, les relations linéaires obtenues possèdent toutes la même ordonnée à l'origine. Ainsi, on montre que la quantification des pertes en performance photovoltaïque est valide pour toute longueur d'onde utilisée, prouvant alors une robustesse supplémentaire de l'invention.

En outre, les mesures s'effectuent à température ambiante, sont rapides et durent quelques secondes. La technique de mesure est purement optique et ne nécessite aucun contact électrique de la cellule solaire. La mesure peut donc intervenir à tout moment dans la fabrication de la cellule, et tout particulièrement dans les premières étapes (dépôt de l'absorbeur photovoltaïque, de la couche tampon).

**Revendications**

1. Procédé de caractérisation d'une couche mince réalisée dans un matériau semi-conducteur à propriétés photovoltaïques, le procédé comportant:

   a. éclairer le matériau de la couche mince en utilisant une pluralité d'impulsions lumineuses successives présentant des longueurs d'onde respectives, différentes entre elles, chacune inférieure à une longueur d'onde de gap d'une portion de ladite couche mince ;
   b. [2]effectuer des mesures résolues en temps de la décroissance d'une luminescence, décroissante en fonction du temps, issue du matériau après chaque impulsion lumineuse,
   c. estimer, en fonction de chaque mesure de luminescence, une densité de défauts ($\Psi_D$) dans une portion respective du matériau de la couche mince

2. Procédé selon la revendication 1, comportant :

   - élaborer un modèle de ladite décroissance de luminescence au moins en fonction de la densité de défauts ($\Psi_D$) dans le matériau de la couche mince,
   - appliquer le modèle pour une pluralité de valeurs de densité de défauts ($\Psi_D$), et identifier une valeur de densité de défauts qui minimise un écart entre le modèle et la mesure de décroissance de luminescence, et
   - définir la valeur identifiée comme étant l'estimation de la densité de défauts ($\Psi_D$) dans le matériau de la couche mince.

3. Procédé selon l'une des revendications 1 et 2, comportant en outre:

   - estimer, en fonction de la densité de défauts ($\Psi_D$), une tension de circuit ouvert maximale ($\Delta\mu$) du matériau de la couche mince.

4. Procédé selon la revendication 3, dans lequel :

   - à partir d'une pluralité de mesures et d'estimations de la densité de défauts ($\Psi_D$) dans le matériau de la couche mince, on détermine une variation linéaire de la tension de circuit ouvert maximale ($\Delta\mu$) en fonction de la densité de défauts ($\Psi_D$) dans le matériau de la couche mince, et
   - à partir de la variation linéaire, on détermine la tension de circuit ouvert maximale ($\Delta\mu$) du matériau de la couche mince.

5. Procédé selon l'une des revendications précédentes, dans lequel l'estimation de la densité de défauts ($\Psi_D$) est répétée pour une pluralité de points de la couche mince, en vue de cartographier une répartition spatiale de la densité de défauts ($\Psi_D$) dans la couche mince.

6. Procédé selon l'une des revendications 3 à 5, dans lequel l'estimation de tension de circuit ouvert maximale ($\Delta\mu$) est répétée pour une pluralité de points de la couche mince, en vue de cartographier une répartition spatiale de la tension de circuit ouvert maximale ($\Delta\mu$) de la couche mince.

7. Procédé selon l'une des revendications précédentes, dans lequel ladite couche mince est une première couche mince d'un empilement comportant en outre une deuxième couche mince déposée sur la première couche mince, le procédé comportant en outre :

   - éclairer l'empilement pendant au moins une impulsion lumineuse, avec une lumière incluant au moins une longueur d'onde inférieure à une longueur d'onde d'un gap d'une interface entre les première et deuxième couches,
   - mesurer, après ladite impulsion lumineuse, une luminescence issue de ladite interface, décroissante en fonction du temps, et
   - estimer, en fonction de ladite mesure de luminescence, une densité de défauts ($\Psi_D$) dans l'interface entre les première et deuxième couches minces.

**8.** Procédé selon l'une des revendications précédentes, mis en oeuvre pour un contrôle de qualité de fabrication d'un produit photorécepteur comportant un dépôt dudit matériau en couche mince, le procédé comportant :

- comparer la densité de défauts ($\Psi_D$) estimée dans le matériau de la couche mince à une valeur seuil (THR1), et

- en cas de dépassement de la densité de défauts estimée au-delà de la valeur seuil, rejeter le dépôt dudit matériau en couche mince comme non conforme,
- sinon, poursuivre la fabrication du produit photorécepteur.

**9.** Procédé selon l'une des revendications 3, 4 et 6, mis en oeuvre pour un contrôle de qualité de fabrication d'un produit photorécepteur comportant un dépôt dudit matériau en couche mince, le procédé comportant :

- comparer, à une valeur seuil (THR2), la tension estimée de circuit ouvert maximale ($\Delta\mu$) du matériau de la couche mince, et
- si la tension estimée de circuit ouvert maximale ($\Delta\mu$) est inférieure à la valeur seuil (THR2), rejeter le dépôt dudit matériau en couche mince comme non conforme,
- sinon, poursuivre la fabrication du produit photorécepteur.

**10.** Procédé selon la revendication 7, mis en oeuvre pour un contrôle de qualité de fabrication d'un produit photorécepteur comportant un empilement desdites première et deuxième couches minces, le procédé comportant :

- comparer la densité de défauts estimée à l'interface entre les première et deuxième couches à une valeur seuil, et

- en cas de dépassement de la densité de défauts estimée au-delà de la valeur seuil, rejeter l'empilement comme non conforme,
- sinon, poursuivre la fabrication du produit photorécepteur.

**11.** Procédé selon l'une des revendications 8, 9, 10, dans lequel le produit photorécepteur est une cellule solaire comportant un alliage comme matériau semi-conducteur à propriétés photovoltaïques de ladite couche mince.

**12.** Procédé selon la revendication 11, dans lequel ledit matériau est un chalcogénure de stoechiométrie I-III-VI$_2$.

**13.** Dispositif de caractérisation d'une couche mince réalisée dans un matériau semi-conducteur à propriétés photovoltaïques, comportant au moins, pour la mise en oeuvre du procédé selon l'une des revendications précédentes :

- une source d'éclairement (1, 2, 3, 6) comprenant un laser à impulsions, pour éclairer le matériau de la couche mince,
- une unité de comptage de photons (7, 8, 9, 19, 20, 15, 16, 18) pour mesurer la luminescence issue du matériau, et
- une unité de traitement informatique (17) pour estimer la densité de défauts ($\Psi_D$) dans le matériau de la couche mince.

**14.** Programme informatique comportant des instructions au moins pour l'estimation de la densité de défauts ($\Psi_D$) dans le matériau de la couche mince, pour la mise en oeuvre du procédé selon l'une des revendications 1 à 13, lorsque ce programme est exécuté par un processeur.

**15.** Programme informatique selon la revendication 14, comportant en outre des instructions pour l'estimation de la tension de circuit ouvert maximale ($\Delta\mu$) du matériau de la couche mince, lorsque ce programme est exécuté par un processeur.

FIG. 1

FIG. 2

$$\Delta\mu(\Psi_D) = -6,3 \times 10^{-17}\Psi_D + 0,82$$

FIG. 3

FIG. 4

FIG. 5

ΨD

FIG. 6

Δμ

FIG. 7

FIG. 8

FIG. 9A

FIG. 9B

FIG. 10

FIG. 11

FIG. 12

Exc. Las. puls. — S1

Lum / t — S2

Err / min / $\Psi_D$ — S3

X, Y

$\Psi_D$ (min) — S4

$\Psi_D$ >THR1 — S5
OK → REJ — S6
KO

$\Delta\mu$ / $\Psi_D$ — S7

$\Delta\mu$ — S8

$\Delta\mu$ >THR2 — S9

CHG λ — S10

Europäisches
Patentamt

European
Patent Office

Office européen
des brevets

**RAPPORT DE RECHERCHE EUROPEENNE**

Numéro de la demande

EP 18 17 2737

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2013/122612 A1 (REPINS INGRID L [US] ET AL) 16 mai 2013 (2013-05-16) | 1,2, 5-11,13, 14 | INV. G01N21/95 G01N21/64 |
| Y | * alinéa [0003] - alinéa [0010]; figures 1, 2, 4-7 * <br> * alinéa [0039] * <br> * alinéa [0051] - alinéa [0059]; revendications 1, 6, 7, 10 * <br> ----- | 3,4,12, 15 | H01L21/66 H02S50/00 |
| Y | US 2013/140431 A1 (YVES LACROIX [JP]) 6 juin 2013 (2013-06-06) <br> * alinéa [0002]; figures 1-5 * <br> * alinéa [0070] - alinéa [0073] * <br> * alinéa [0089] - alinéa [0095] * <br> * alinéa [0164]; revendications 1, 5, 6 * <br> ----- | 12 | |
| Y | US 2015/323457 A1 (TRUPKE THORSTEN [AU] ET AL) 12 novembre 2015 (2015-11-12) <br> * alinéa [0002] - alinéa [0008]; figures 1, 2, 7 * <br> * alinéa [0108] * <br> * alinéa [0135] - alinéa [0136]; revendications 1-3 * <br> ----- | 3,4,15 | |
| A | US 2012/012756 A1 (BECK MARKUS E [US] ET AL) 19 janvier 2012 (2012-01-19) <br> * alinéa [0002] - alinéa [0003]; revendications 1, 15; figures 1-7 * <br> ----- | 1-15 | DOMAINES TECHNIQUES RECHERCHES (IPC) <br> G01N <br> H01L <br> H02S |
| A | US 2007/000434 A1 (BUCZKOWSKI ANDRZEJ [US]) 4 janvier 2007 (2007-01-04) <br> * abrégé; revendication 1 * <br> ----- | 1-15 | |
| A | WO 2011/120089 A1 (BT IMAGING PTY LTD [AU]; MAXWELL IAN ANDREW [AU]) 6 octobre 2011 (2011-10-06) <br> * revendication 1 * <br> ----- | 1-15 | |

-/--

Le présent rapport a été établi pour toutes les revendications

| Lieu de la recherche | Date d'achèvement de la recherche | Examinateur |
|---|---|---|
| Berlin | 21 septembre 2018 | Koll, Hermann |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

.......................................................................
& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 18 17 2737

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2011/117681 A1 (BARDOS ROBERT ANDREW [AU] ET AL) 19 mai 2011 (2011-05-19) * abrégé; revendication 1 * ----- | 1-15 | |
| A | US 2011/188733 A1 (BARDOS ROBERT ANDREW [AU] ET AL) 4 août 2011 (2011-08-04) * abrégé; revendication 1 * ----- | 1-15 | |
| A | US 2010/220316 A1 (FINAROV MOSHE [IL]) 2 septembre 2010 (2010-09-02) * abrégé; revendication 1 * ----- | 1-15 | |
| X | US 2012/025100 A1 (ALLENIC ARNOLD [US] ET AL) 2 février 2012 (2012-02-02) * alinéa [0010] - alinéa [0014]; revendications 1, 3, 7; figure 1 * ----- | 13 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| Berlin | 21 septembre 2018 | Koll, Hermann |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

....................................................

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**
                                                           EP 18 17 2737

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-09-2018

| Document brevet cité au rapport de recherche | Date de publication | Membre(s) de la famille de brevet(s) | Date de publication |
|---|---|---|---|
| US 2013122612 A1 | 16-05-2013 | AUCUN | |
| US 2013140431 A1 | 06-06-2013 | CA 2805718 A1 | 23-08-2012 |
| | | CN 103080730 A | 01-05-2013 |
| | | EP 2677302 A1 | 25-12-2013 |
| | | JP 5843114 B2 | 13-01-2016 |
| | | JP WO2012111093 A1 | 03-07-2014 |
| | | KR 20130054355 A | 24-05-2013 |
| | | TW 201250230 A | 16-12-2012 |
| | | US 2013140431 A1 | 06-06-2013 |
| | | WO 2012111093 A1 | 23-08-2012 |
| US 2015323457 A1 | 12-11-2015 | AU 2009230877 A1 | 08-10-2009 |
| | | CN 102017191 A | 13-04-2011 |
| | | CN 104022056 A | 03-09-2014 |
| | | EP 2272101 A1 | 12-01-2011 |
| | | JP 5936657 B2 | 22-06-2016 |
| | | JP 2011516374 A | 26-05-2011 |
| | | JP 2015038481 A | 26-02-2015 |
| | | KR 20100131512 A | 15-12-2010 |
| | | TW 201000887 A | 01-01-2010 |
| | | US 2011025839 A1 | 03-02-2011 |
| | | US 2015323457 A1 | 12-11-2015 |
| | | WO 2009121133 A1 | 08-10-2009 |
| US 2012012756 A1 | 19-01-2012 | AUCUN | |
| US 2007000434 A1 | 04-01-2007 | TW 200715441 A | 16-04-2007 |
| | | US 2007000434 A1 | 04-01-2007 |
| | | WO 2007005438 A2 | 11-01-2007 |
| WO 2011120089 A1 | 06-10-2011 | CN 203055871 U | 10-07-2013 |
| | | WO 2011120089 A1 | 06-10-2011 |
| US 2011117681 A1 | 19-05-2011 | CN 102089874 A | 08-06-2011 |
| | | EP 2319073 A1 | 11-05-2011 |
| | | JP 2011527510 A | 27-10-2011 |
| | | US 2011117681 A1 | 19-05-2011 |
| | | WO 2010003186 A1 | 14-01-2010 |
| US 2011188733 A1 | 04-08-2011 | CN 101861643 A | 13-10-2010 |
| | | CN 103000756 A | 27-03-2013 |
| | | EP 2195833 A1 | 16-06-2010 |
| | | JP 2010537434 A | 02-12-2010 |
| | | KR 20100075875 A | 05-07-2010 |
| | | TW 200931554 A | 16-07-2009 |

EPO FORM P0460

Pour tout renseignement concernant cette annexe : voir Journal Officiel de l'Office européen des brevets, No.12/82

page 1 de 2

**ANNEXE AU RAPPORT DE RECHERCHE EUROPEENNE
RELATIF A LA DEMANDE DE BREVET EUROPEEN NO.**

EP 18 17 2737

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-09-2018

| Document brevet cité au rapport de recherche | Date de publication | Membre(s) de la famille de brevet(s) | | Date de publication |
|---|---|---|---|---|
| | | US | 2011188733 A1 | 04-08-2011 |
| | | WO | 2009026661 A1 | 05-03-2009 |
| US 2010220316 A1 | 02-09-2010 | EP | 2385362 A1 | 09-11-2011 |
| | | US | 2010220316 A1 | 02-09-2010 |
| US 2012025100 A1 | 02-02-2012 | CN | 103080731 A | 01-05-2013 |
| | | US | 2012025100 A1 | 02-02-2012 |
| | | WO | 2012016233 A1 | 02-02-2012 |

EPO FORM P0460

Pour tout renseignement concernant cette annexe : voir Journal Officiel de l'Office européen des brevets, No.12/82

page 2 de 2

**EP 3 407 055 A1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015323457 A
- US 2012012756 A1
- US 2013122612 A1
- US 2013140431 A1